# EUROPEAN PATENT APPLICATION

(11) **EP 4 852 687 A1**
(43) Date of publication of application: **09.12.2026**
(21) Application number: 25767403.6
(22) Date of filing: 05.03.2025
(51) Int. Cl.: H10K 85/50

(54) **PEROVSKITE MATERIAL, SOLAR CELL, PREPARATION METHOD THEREFOR, ELECTRICAL DEVICE AND POWER GENERATION EQUIPMENT**

(30) Priority: 08.03.2024 CN 202410269735
(71) Applicant: Contemporary Amperex Technology Co., Limited, Ningde, Fujian 352100 (CN)
(72) Inventor: LIU, Xiao, Ningde, Fujian 352100 (CN); SHI, Ruoxuan, Ningde, Fujian 352100 (CN); TU, Bao, Ningde, Fujian 352100 (CN); CHEN, Changsong, Ningde, Fujian 352100 (CN)
(74) Representative: Lorenz Seidler Gossel Part. mbB
(86) International application number: PCT/CN2025/080835
(87) International publication number: WO 2025/185665

(57) **Abstract**

Disclosed in the present application are a perovskite material, a solar cell, a preparation method therefor, an electrical device and power generation equipment. The general formula of the perovskite material is MₓFA_{y}A_{1-x-y}BX₃, M⁺ being a N-containing monovalent cation, FA⁺ being formamidinium, A being at least one of inorganic or organic monovalent cations, B being at least one inorganic divalent cation, and X being at least one monovalent anion. The embodiment of the present application dopes a formamidinium-containing perovskite material with a N-containing monovalent cation so as to improve same, thus improving the stability of corresponding perovskite solar cells.

## Description

The present disclosure claims priority to Chinese Patent Application No. 2024102697358, filed on March 8, 2024 and entitled "PEROVSKITE MATERIAL, SOLAR CELL, PREPARATION METHOD THEREFOR, ELECTRICAL DEVICE AND POWER GENERATION EQUIPMENT", which is incorporated herein by reference in its entirety.

### TECHNICAL FIELD

The present invention relates to the technical field of photovoltaic devices, and in particular, to a perovskite material, a solar cell, a preparation method therefor, an electrical device, and power generation equipment.

### BACKGROUND

The information provided in this section is merely background information related to the present application and does not necessarily constitute prior art.

Perovskite solar cells have broad application prospects due to the advantages thereof such as high conversion efficiency and ease of preparation. However, the perovskite material is prone to instability of the crystalline phase structure, which directly affects the device stability of the cell and is an important factor affecting the service life of perovskite solar cells.

### SUMMARY

In view of the technical problems existing in the background art, the present application provides a perovskite material, a solar cell, a preparation method therefor, an electrical device, and power generation equipment, aiming to improve the device stability of solar cells.

To achieve the above objective, a first aspect of the present application provides a perovskite material. The general formula of the perovskite material is MₓFA_{y}A_{1-x-y}BX₃, 0 < x ≤ 0.1, 0.5 ≤ y < 1, and 1-x-y ≥ 0;
where M⁺ includes an N-containing monovalent cation; FA⁺ is a formamidinium cation; A⁺ includes at least one of inorganic or organic monovalent cations, B²⁺ includes at least one inorganic divalent cation, and X⁻ includes at least one monovalent anion.

In the embodiments of the present application, by doping a formamidinium cation-containing perovskite material with the N-containing monovalent cation, a hydrogen bond is formed between the N-containing monovalent cation and the formamidinium cation, which enhances the stability of the formamidinium cation in the lattice, thereby stabilizing a crystalline phase structure of the perovskite material, so that the perovskite material is less prone to defects such as X⁻ ion vacancy defects, achieving defect passivation of the perovskite material. Moreover, since the X⁻ ion vacancy defects of the perovskite material are both carrier recombination sites and migration channels for X ions, the passivation of defects such as X⁻ ion vacancy defects in the perovskite material is also conducive to reducing ion migration channels and mitigating the impact of ion migration on the performance of corresponding solar cells, thereby improving the stability of corresponding perovskite solar cells.

In some embodiments, A⁺ includes one or more of MA⁺, Cs⁺, Rb⁺, K⁺, DMA⁺, EA⁺, and GA⁺; B²⁺ includes one or more of Pb²⁺, Sn²⁺, Ge²⁺, Cd²⁺, Sb²⁺, Zn²⁺, Mn²⁺, and Ca²⁺; and X⁻ includes one or more of I⁻, Br⁻, Cl⁻, SCN⁻, HCOO⁻, CH₃COO⁻, CF₃COO⁻, CH₃SO₃⁻, CF₃SO₃⁻, and CN⁻.

In the embodiments of the present application, by providing specific schemes for A⁺, B²⁺, and X⁻ ions of the formamidinium cation-containing perovskite material, it is conductive to making the crystal structure of the corresponding perovskite material have higher stability.

In some embodiments, X⁻ ions include I⁻, and a molar ratio of I⁻ in the X⁻ ions is greater than or equal to 0.5.

In the embodiments of the present application, by defining that the anions of the formamidinium cation-containing perovskite material at least include iodide ions, the iodide ions have a relatively large ionic radius, and the covalent interaction between the anions of the perovskite material and the metal cations is relatively strong, so that the corresponding perovskite material has relatively high stability.

In some embodiments, A⁺ includes one or both of Cs⁺ and MA⁺; and a molar ratio of A⁺ in a sum of M⁺, FA⁺ and A⁺ ions is less than or equal to 0.4.

In the embodiments of the present application, by doping the formamidinium cation-containing perovskite material with cesium cations and/or methylammonium cations having a relatively small ionic radius, the formation energy of an α-phase is effectively reduced by lowering the tolerance factor, and the formation of δ-phase impurities during the production process is reduced, thereby suppressing unfavorable phase transitions during the use of the perovskite material and improving the stability of the formamidinium cation-containing perovskite material. Moreover, since the radius of the N-containing monovalent cation is greater than that of the formamidinium cation, and the radius of the cesium cation and/or methylammonium cation is smaller than that of the formamidinium cation, the radii of the N-containing monovalent cation and the cesium cation and/or methylammonium cation are balanced with each other, which is conducive to reducing local tensile and compressive strains in the perovskite lattice and improving the stability of the formamidinium cation-containing perovskite material.

In some embodiments, A⁺ ions include Cs⁺, and a molar ratio of Cs⁺ in the sum of the M⁺, FA⁺ and A⁺ ions is less than or equal to 0.4.

In the embodiments of the present application, by doping the formamidinium cation-containing perovskite material with cesium cations having a relatively small ionic radius, the formation energy of the α-phase is effectively reduced by lowering the tolerance factor, and the formation of δ-phase impurities during the production process is reduced, thereby suppressing unfavorable phase transitions during the use of the perovskite material and improving the stability of the formamidinium cation-containing perovskite material. Moreover, since the radius of the N-containing monovalent cation is greater than that of the formamidinium cation, and the radius of the cesium cation is smaller than that of the formamidinium cation, the radii of the N-containing monovalent cation and the cesium cation are balanced with each other, which is conducive to reducing local tensile and compressive strains in the perovskite lattice and improving the stability of the formamidinium cation-containing perovskite material.

In some embodiments, B²⁺ includes Pb²⁺ and Sn²⁺, and a molar ratio of Pb²⁺ in B²⁺ ions is greater than 0 and less than 1.

In the embodiments of the present application, by selecting Pb²⁺ and Sn²⁺ as the metal cations, the bandgap of the formed perovskite material is regulated, so that the formed perovskite material has a relatively narrow bandgap, a relatively high absorption coefficient, and a relatively low free carrier recombination rate, thereby facilitating the improvement of the photoelectric conversion efficiency of the corresponding perovskite solar cell.

In some embodiments, the radius of the N-containing monovalent cation is greater than that of the formamidinium cation.

In the embodiments of the present application, since the radius of the N-containing monovalent cation is greater than that of the formamidinium cation, the doping with the N-containing monovalent cation having a relatively large radius balances with the radii of other A-site cations, thereby achieving regulation of lattice strain and stabilization of the α-phase without negatively affecting the bandgap.

In some embodiments, the N-containing monovalent cation includes one or more of a substituted or unsubstituted N-containing heterocyclic cation and a substituted or unsubstituted guanidinium cation.

In the embodiments of the present application, by providing the N-containing monovalent cation, the hydrogen bonding interaction between the N-containing monovalent cation and the formamidinium cation is enhanced, and the migration of the formamidinium cation and the release of formamidine gas are reduced, thereby effectively improving the stability of the corresponding perovskite solar cell.

In some embodiments, the substituted or unsubstituted N-containing heterocyclic cation includes one or more of a substituted or unsubstituted pyrrolyl cation, a substituted or unsubstituted pyrrolidinyl cation, a substituted or unsubstituted piperidinyl cation, a substituted or unsubstituted pyridinyl cation, a substituted or unsubstituted pyrazinyl cation, a substituted or unsubstituted piperazinyl cation, and a substituted or unsubstituted 1,2,3,4-tetrahydro-[1,3,5]triazinyl cation.

In the embodiments of the present application, by providing the above-mentioned substituted or unsubstituted N-containing heterocyclic cation as the N-containing monovalent cation to dope the formamidinium cation-containing perovskite material, X⁻ vacancy defects inside the perovskite crystal and at grain boundaries are passivated, carrier recombination sites and ion migration channels are reduced, the lattice strain of the perovskite material is regulated, the crystalline phase of the perovskite material is stabilized, and the photoelectric conversion efficiency and stability of the perovskite solar cell are improved.

In some embodiments, the N-containing monovalent cation includes one or more of a substituted N-containing heterocyclic cation and a substituted guanidinium cation. A substituent group of the substituted N-containing heterocyclic cation and a substituent group of the substituted guanidinium cation are each independently selected from -D₁ and -L₁-D₁, where L₁ includes an aliphatic hydrocarbon group having 1 to 5 carbon atoms, and D₁ includes one or more of methyl, cyano, carboxyl, trifluoromethanesulfonyl, phenyl, pyridyl, benzylideneamino, amino, acetyl, formyl, halogen, phenyl substituted with 1 to 4 halogens, benzylideneamino substituted with 1 to 2 halogens, and (trifluoromethyl)phenyl.

In the embodiments of the present application, by doping the formamidinium cation-containing perovskite material with a multifunctional N-containing cation, the X⁻ vacancy defects inside the perovskite crystal and at the grain boundaries are passivated, and the cation itself also plays a role in self-passivation, which is further beneficial to reducing defects inside the perovskite crystal and at the grain boundaries. In addition, the seed formation energy and crystal growth rate during the crystallization process can be regulated, further improving the crystalline quality of a formed perovskite layer, which is beneficial to further improving the photoelectric conversion efficiency of the corresponding perovskite solar cell.

In some embodiments, the N-containing monovalent cation includes one or more of 3-bromopyridinium cation, 1-cyanoguanidinium cation, 1-(trifluoromethanesulfonyl)guanidinium cation, 1-acetylguanidinium cation, 1,2,3,4-tetrahydro-[1,3,5]triazinium cation, 1-(2,6-dichlorobenzylideneamino)guanidinium cation, and 1-(2-chloroethyl)piperidinium cation.

In the embodiments of the present application, by providing specific N-containing monovalent cations to dope the formamidinium cation-containing perovskite material, defects of the perovskite material are passivated, ion migration channels are reduced, the lattice strain of the perovskite material is regulated, the crystalline phase of the perovskite material is stabilized, and the stability of the corresponding solar cell is improved.

According to a second aspect, an embodiment of the present application provides a solar cell, which includes:
a light-absorbing layer, where a material forming the light-absorbing layer includes a perovskite material,
where the perovskite material is any one of the perovskite materials according to the first aspect.

The embodiment of the present application provides a solar cell including any one of the above perovskite materials. Since the perovskite material has reduced defects, reduced ion migration channels, and a stable crystalline phase, the formed solar cell has good stability.

According to a third aspect, an embodiment of the present application provides a method for preparing a solar cell, which includes:
preparing a perovskite precursor solution according to a molar ratio of components of a perovskite material for forming a light-absorbing layer, where the perovskite material is any one of the perovskite materials according to the first aspect; and
forming the perovskite precursor solution on a substrate, followed by curing treatment to obtain the light-absorbing layer.

In the embodiments of the present application, by providing the method for preparing a solar cell and using the designed perovskite precursor solution, the light-absorbing layer with reduced defects, reduced ion migration channels, and a stable crystalline phase is formed, thereby achieving an improvement in the stability of the solar cell.

In some embodiments, the perovskite precursor solution includes a precursor of the N-containing monovalent cation, and the precursor of the N-containing monovalent cation includes a salt of the N-containing monovalent cation.

In the embodiments of the present application, by providing the salt of the N-containing monovalent cation as the precursor of the N-containing monovalent cation, doping modification of the formamidinium cation-containing perovskite material is easily achieved.

In some embodiments, the anion corresponding to the salt of the N-containing monovalent cation includes one or more of iodide anion I⁻, bromide anion Br⁻, chloride anion Cl⁻, thiocyanate anion SCN⁻, carboxylate anion HCOO⁻, acetate anion CH₃COO⁻, trifluoroacetate anion CF₃COO⁻, methanesulfonate anion CH₃SO₃⁻, trifluoromethanesulfonate anion CF₃SO₃⁻, and cyanate anion CN⁻.

In the embodiments of the present application, by providing the above-mentioned specific anions corresponding to the salt of the N-containing monovalent cation, when the cation of the salt of the N-containing monovalent cation participates in the doping modification of the formamidinium cation-containing perovskite material, an anion thereof participates in forming the X-site anion of the formamidinium cation-containing perovskite material, thereby improving the utilization efficiency of the salt of the N-containing monovalent cation, and avoiding the introduction of anions other than the X-site anion into the reaction system, thus reducing adverse effects on the formed perovskite material.

In some embodiments, the precursor of the N-containing monovalent cation includes one or more of hydrochloride, bromate, iodate, thiocyanate, formate, acetate, trifluoroacetate, trifluoromethanesulfonate, and cyanate of 3-bromopyridine, 1-cyanoguanidine, 1-(trifluoromethanesulfonyl)guanidine, 1-acetylguanidine, 1,2,3,4-tetrahydro-[1,3,5]triazine, 1-(2,6-dichlorobenzylideneamino)guanidine, and 1-(2-chloroethyl)piperidine.

In the embodiments of the present application, by providing some specific precursors of the N-containing monovalent cation to dope the formamidinium cation-containing perovskite material, defects of the perovskite material is passivated, ion migration channels are reduced, the lattice strain of the perovskite material is regulated, the crystalline phase of the perovskite material is stabilized, and the stability of the corresponding perovskite solar cell is improved.

According to a fourth aspect, an embodiment of the present application provides an electrical device, which includes the solar cell according to the second aspect; or includes a solar cell prepared by the method for preparing a solar cell according to the third aspect.

In the embodiments of the present application, the solar cell serves as an electric energy source for the electrical device, enabling the normal operation of the electrical device. The electrical device employs the solar cell provided in the present application, and thus has at least the same advantages as the solar cell, which improves the cell performance of the electrical device.

According to a fifth aspect, an embodiment of the present application provides power generation equipment, which includes the solar cell according to the second aspect; or includes a solar cell prepared by the method for preparing a solar cell according to the third aspect.

In the embodiments of the present application, the solar cell serves as an energy source for the power generation equipment, enabling the output of electrical energy from the power generation equipment. The power generation equipment employs the solar cell provided in the present application, and thus has at least the same advantages as the solar cell, which improves the power generation performance of the power generation equipment.

### BRIEF DESCRIPTION OF THE DRAWINGS

To describe the technical solutions in the embodiments of the present application more clearly, the accompanying drawings required for describing the embodiments are briefly described below. Apparently, the accompanying drawings in the following description show some embodiments of the present application, and those of ordinary skill in the art may still derive other drawings from these accompanying drawings without creative efforts.
FIG. 1 is a schematic structural diagram of a solar cell according to an embodiment of the present application;
FIG. 2 is a schematic structural diagram of an electrical device according to an embodiment of the present application; and
FIG. 3 is a schematic structural diagram of power generation equipment according to an embodiment of the present application.

### Description of reference signs:

100 - solar cell; 10 - light-absorbing layer; 1000 - electrical device; 2000 - power generation equipment.

**DETAILED DESCRIPTION**

The present application will be further described below in conjunction with specific embodiments. It should be understood that these specific embodiments are only for describing the present application and are not intended to limit the scope of the present application.

For the sake of brevity, only some value ranges are specifically disclosed herein. However, any lower limit may be combined with any upper limit to form a range not explicitly recited. Similarly, any lower limit may be combined with other lower limits to form a range not explicitly recited, and any upper limit may be combined with any other upper limits to form a range not explicitly recited. In addition, each individually disclosed point or single value may serve as a lower limit or an upper limit and may be combined with any other point or single value, or with other lower limits or upper limits, to form a range not explicitly recited.

In the description herein, unless otherwise stated, the term "or" is inclusive. That is, the phrase "A or B" means "A, B, or both A and B". More specifically, any of the following conditions satisfies the condition "A or B": A is true (or present) and B is false (or not present); A is false (or not present) and B is true (or present); or both A and B are true (or present).

In the description herein, it should be noted that, unless otherwise stated, "or more" and "or less" encompass the recited number, and "more" in "one or more" means two or more.

Unless otherwise stated, the terms used in the present application have well-known meanings as commonly understood by those skilled in the art. Unless otherwise specified, the values of the parameters mentioned in the present application may be measured by various measurement methods commonly used in the art (for example, the tests may be performed according to the methods given in the embodiments of the present application).

The bandgap of FA⁺-based perovskite materials (formamidinium-based perovskite materials) is relatively close to the Shockley-Queisser limit of 1.34 eV, making them suitable as light-absorbing materials. Moreover, due to the diamino groups of the formamidinium cation FA⁺, stronger interactions exist within FA⁺-based perovskite materials, which endow the FA⁺-based perovskite materials with relatively good thermal stability. However, due to the relatively large ionic radius of the formamidinium cation FA⁺ and the relatively large lattice strain, they are susceptible to temperature, humidity, and light, causing migration of the formamidinium cation FA⁺ and release of formamidine FA(0) gas formed by deprotonation of FA⁺. In addition, the rotational disorder of the formamidinium cation FA⁺ is relatively large, and the formation energy for forming the crystalline phase with good photoactivity is relatively high. Even if the crystalline phase with good photoactivity is formed, it tends to transform into a crystalline phase with poor photoactivity. All the above factors tend to cause a decrease in the stability of the FA⁺-based perovskite materials.

To solve the above technical problems, the embodiments of the present application provide a perovskite material, a solar cell, a preparation method therefor, an electrical device, and power generation equipment.

The technical solutions described in the embodiments of the present application are applicable to the perovskite material, the solar cell, the preparation method therefor, the electrical device, and the power generation equipment. The solar cell disclosed in the present application may be used in perovskite-containing tandem solar cells, such as perovskite-perovskite tandem solar cells, silicon-perovskite tandem solar cells, and perovskite-heterojunction tandem solar cells, which is not limited in the present application.

The present application will be described in detail below with reference to the accompanying drawings and embodiments.

To achieve the above objective, a first aspect of the present application provides a perovskite material. The general formula of the perovskite material is MₓFA_{y}A_{1-x-y}BX₃, 0 < x ≤ 0.1, 0.5 ≤ y < 1, and 1-x-y ≥ 0.

Where M⁺ includes an N-containing monovalent cation; FA⁺ is a formamidinium cation; A⁺ includes at least one of inorganic or organic monovalent cations, B²⁺ includes at least one inorganic divalent cation, and X⁻ includes at least one monovalent anion.

A perovskite material refers to a material having the same crystal structure as CaTiO₃, which exhibits a cubic crystalline phase in a stable state and serves as a main material for forming a perovskite layer.

In the perovskite provided in the embodiments of the present application, the cations adopt the N-containing monovalent cation to dope the formamidinium cation FA⁺. A hydrogen bond is formed between the N-containing monovalent cation and the formamidinium cation FA⁺, which reduces the lattice strain of the FA⁺-based perovskite material, and increases the energy barrier for the migration of the formamidinium cation FA⁺ and the release of formamidine FA(0) gas formed by deprotonation of FA⁺, thereby reducing the migration of the formamidinium cation FA⁺ and the release of formamidine FA(0) gas formed by deprotonation of FA⁺. In addition, the hydrogen bond is formed between the N-containing monovalent cation and the formamidinium cation FA⁺, the rotational disorder of the formamidinium cation FA⁺ is reduced, and the formation energy for forming the crystalline phase with good photoactivity is lowered, so that the transition from the crystalline phase with good photoactivity to a crystalline phase with poor photoactivity is less likely to occur. All the above factors are conducive to improving the stability of the FA⁺-based perovskite material.

That A⁺ includes at least one of inorganic or organic monovalent cations means that A⁺ may include only inorganic monovalent cations, or may include only organic monovalent cations, or may include both inorganic and organic monovalent cations, which is determined as specifically required.

That B²⁺ includes at least one inorganic divalent cation means that B²⁺ may include only one inorganic divalent cation, or may include a plurality of inorganic divalent cations, which is determined as specifically required.

That X⁻ includes at least one monovalent anion means that X⁻ may include only one monovalent anion, or may include a plurality of monovalent anions, which is determined as specifically required.

In some embodiments, the value of x may be 0.01, 0.02, 0.03, 0.04, 0.05, 0.06, 0.07, 0.08, 0.09, 0.1, or the like, or a range formed by any two of the above values, for example, may be 0.01 to 0.04, 0.02 to 0.05, 0.03 to 0.06, 0.04 to 0.07, 0.05 to 0.08, 0.06 to 0.09, 0.07 to 0.1, or the like.

In some embodiments, the value of y may be 0.5, 0.55, 0.6, 0.65, 0.7, 0.75, 0.8, 0.85, 0.9, 0.95, 0.99, or the like, or a range formed by any two of the above values, for example, may be 0.5 to 0.7, 0.55 to 0.75, 0.6 to 0.8, 0.65 to 0.85, 0.7 to 0.9, 0.75 to 0.95, 0.8 to 0.99, or the like.

In the embodiments of the present application, by doping a formamidinium cation-containing perovskite material with the N-containing monovalent cation, a hydrogen bond is formed between the N-containing monovalent cation and the formamidinium cation, which enhances the stability of the formamidinium cation in the lattice, thereby stabilizing a crystalline phase structure of the perovskite material, so that the perovskite material is less prone to defects such as X⁻ ion vacancy defects, achieving defect passivation of the perovskite material. Moreover, since the X⁻ ion vacancy defects of the perovskite material are both carrier recombination sites and migration channels for X ions, the passivation of defects such as X⁻ ion vacancy defects in the perovskite material is also conducive to reducing ion migration channels and mitigating the impact of ion migration on the performance of corresponding solar cells, thereby improving the stability of corresponding perovskite solar cells.

In some embodiments, A⁺ includes one or more of methylammonium cation MA⁺, cesium cation Cs⁺, rubidium cation Rb⁺, potassium cation K⁺, dimethylammonium cation DMA⁺, ethylenediammonium cation EA⁺, and guanidinium cation GA⁺; and/or B²⁺ includes one or more of lead cation Pb²⁺, tin cation Sn²⁺, germanium cation Ge²⁺, cadmium cation Cd²⁺, antimony cation Sb²⁺, zinc cation Zn²⁺, manganese cation Mn²⁺, and calcium cation Ca²⁺; and/or X⁻ includes one or more of iodide anion I⁻, bromide anion Br⁻, chloride anion Cl⁻, thiocyanate anion SCN⁻, carboxylate anion HCOO⁻, acetate anion CH₃COO⁻, trifluoroacetate anion CF₃COO⁻, methanesulfonate anion CH₃SO₃⁻, trifluoromethanesulfonate anion CF₃SO₃⁻, and cyanate anion CN⁻.

Herein, the monovalent cation A⁺ is used for doping the formamidinium cation FA⁺ and for functioning together with the N-containing monovalent cation M⁺, further increasing the hydrogen bonds formed with the formamidinium cation FA⁺, reducing the migration of the formamidinium cation FA⁺ and the release of formamidine FA(0) gas formed by deprotonation of FA⁺. In addition, the rotational disorder of the formamidinium cation FA⁺ is also reduced, and the formation energy for forming the crystalline phase with good photoactivity is lowered, so that the transition from the crystalline phase with good photoactivity to a crystalline phase with poor photoactivity is less likely to occur. All the above factors are conducive to improving the stability of the FA⁺-based perovskite material.

In the embodiments of the present application, by providing specific schemes for A⁺, B²⁺, and X⁻ ions of the formamidinium cation-containing perovskite material, it is conductive to making the crystal structure of the corresponding perovskite material have higher stability.

In some embodiments, X⁻ ions include I⁻, and a molar ratio of I⁻ in the X⁻ ions is greater than or equal to 0.5.

In the general formula MₓFA_{y}A_{1-x-y}BX₃ of the perovskite material, the molar ratio of the N-containing monovalent cation M⁺ to the formamidinium cation FA⁺ to the monovalent cation A⁺ to the divalent cation B²⁺ to the anion X⁻ is x:y:1-x-y:1:3. That the molar ratio of the iodide anion I⁻ in the X⁻ ions is greater than or equal to 0.5 means that the mole number of the iodide anion I⁻ accounts for 50% or above of the total mole number of the X⁻ ions, that is, the subscript of the iodide anion I⁻ in the general formula of the perovskite material is greater than or equal to 1.5 and less than or equal to 3.

In some embodiments, the molar ratio of the iodide anion I⁻ in the X⁻ ions may be 100%, that is, all X⁻ ions in the perovskite material are iodide anions I⁻, and the corresponding general formula of the perovskite material is MₓFA_{y}A_{1-x-y}BI₃. Due to the relatively large ionic radius of the iodide anion I⁻, the covalent interaction between the iodide anion I⁻ and the divalent cation B²⁺ is relatively strong, and the corresponding perovskite material has relatively high stability.

In some embodiments, the molar ratio of the iodide anion I⁻ in the X⁻ ions is greater than or equal to 0.5 and less than 1, that is, the subscript of the iodide anion I⁻ in the general formula of the perovskite material is greater than or equal to 1.5 and less than 3, meaning that the X⁻ ions are formed by mixing at least two anions. Due to the different ionic radii of the two anions, the charge around the divalent cation B²⁺ is shifted, and the chemical bond energy between the B-X ions inside the crystal structure is increased, causing the octahedra to contract and distort, thereby further reducing the lattice constant and improving the stability of the perovskite material.

In some embodiments, the molar ratio of I⁻ in the X⁻ ions may be 0.5, 0.55, 0.6, 0.65, 0.7, 0.75, 0.8, 0.85, 0.9, 0.95, 1, or the like, or a range formed by any two of the above values, for example, may be 0.5 to 0.65, 0.55 to 0.7, 0.6 to 0.75, 0.65 to 0.8, 0.7 to 0.85, 0.75 to 0.9, 0.8 to 0.95, 0.85 to 1, or the like.

In the embodiments of the present application, by defining that the anions of the formamidinium cation-containing perovskite material at least include iodide ions, the iodide ions have a relatively large ionic radius, and the covalent interaction between the anions of the perovskite material and the metal cations is relatively strong, so that the corresponding perovskite material has relatively high stability.

In some embodiments, A⁺ includes one or both of Cs⁺ and MA⁺; and a molar ratio of A⁺ in a sum of M⁺, FA⁺ and A⁺ ions is less than or equal to 0.4. That the molar ratio of A⁺ in the sum of the M⁺, FA⁺ and A⁺ ions is less than or equal to 0.4 means that the molar ratio of Cs⁺ in the sum of the M⁺, FA⁺ and A⁺ ions is less than or equal to 0.4, or that the molar ratio of MA⁺ in the sum of the M⁺, FA⁺ and A⁺ ions is less than or equal to 0.4, or that the molar ratio of a sum of mole numbers of Cs⁺ and MA⁺ to the total mole numbers of the M⁺, FA⁺ and A⁺ ions is less than or equal to 0.4. In the case where A⁺ includes Cs⁺ and MA⁺, the molar ratio of Cs⁺ to MA⁺ is not limited, as long as the molar ratio of the sum of mole numbers of Cs⁺ and MA⁺ to the total mole numbers of the M⁺, FA⁺ and A⁺ ions is less than or equal to 0.4. In some embodiments, in the case where A⁺ includes Cs⁺ and MA⁺, the molar ratio of Cs⁺ to MA⁺ is 1:2.9.

In the embodiments of the present application, by doping the formamidinium cation-containing perovskite material with cesium cations and/or methylammonium cations having a relatively small ionic radius, the formation energy of an α-phase is effectively reduced by lowering the tolerance factor, and the formation of δ-phase impurities during the production process is reduced, thereby suppressing unfavorable phase transitions during the use of the perovskite material and improving the stability of the formamidinium cation-containing perovskite material. Moreover, since the radius of the N-containing monovalent cation is greater than that of the formamidinium cation, and the radius of the cesium cation and/or methylammonium cation is smaller than that of the formamidinium cation, the radii of the N-containing monovalent cation and the cesium cation and/or methylammonium cation are balanced with each other, which is conducive to reducing local tensile and compressive strains in the perovskite lattice and improving the stability of the formamidinium cation-containing perovskite material.

In some embodiments, A⁺ ions include Cs⁺, and a molar ratio of Cs⁺ in the sum of the M⁺, FA⁺ and A⁺ ions is less than or equal to 0.4.

Herein, A⁺ ions include cesium cations Cs⁺. The ionic radius of the cesium cations Cs⁺ is smaller than that of formamidinium cations FA⁺. The doping of the cesium cations Cs⁺ facilitates the release of relatively large internal microstrains in the FA⁺-based perovskite material, enhances the hydrogen bond strength between the formamidinium cations FA⁺ and the [BX₆]⁴⁻ octahedra, reduces the rotation of the [BX₆]⁴⁻ octahedra, and hinders the migration of internal formamidinium cations FA, thereby improving the stability of the FA⁺-based perovskite material.

In some embodiments, the molar ratio of Cs⁺ in the sum of the M⁺, FA⁺ and A⁺ ions may be 0.01, 0.02, 0.05, 0.08, 0.1, 0.12, 0.15, 0.18, 0.2, 0.22, 0.25, 0.28, 0.3, 0.32, 0.35, 0.38, 0.4, or the like, or a range formed by any two of the above values, for example, may be 0 to 0.05, 0.025 to 0.1, 0.08 to 0.15, 0.1 to 0.2, 0.12 to 0.25, 0.15 to 0.28, 0.18 to 0.3, 0.2 to 0.35, 0.25 to 0.4, or the like.

In some embodiments, the general formula of the perovskite material provided in the embodiments of the present application is MₓFA_{y}Cs_{1-x-y}PbI₃, 0 < x ≤ 0.1, 0.5 ≤ y < 1, and 1-x-y > 0, which is equivalent to doping an FAPbI₃ phase with the N-containing monovalent cation and the cesium cation Cs⁺. FAPbI₃ has a relatively broad light absorption range, and at room temperature, exciton dissociation is easy to occur, generating a large number of electron-hole pairs, making it suitable to be used as a light-absorbing layer material with promising application prospects. However, FAPbI₃ undergoes spontaneous phase transition at room temperature, transforming from black α-phase perovskite with good photoactivity to yellow δ-phase non-perovskite with poor photoactivity. This phase transition process hinders the further commercial application of FAPbI₃ perovskite solar cells.

The present application reduces the formation energy of the α-phase FAPbI₃ through doping with the N-containing monovalent cation and the cesium cation Cs⁺, suppresses the transition from the α-phase FAPbI₃ to the δ-phase FAPbI₃, and improves the stability of the corresponding perovskite material. Moreover, since the ionic radii of the N-containing monovalent cation and the cesium cation Cs⁺ have certain difference, the two are balanced with each other, which is conducive to reducing local tensile and compressive strains in the perovskite lattice, and further improving the stability of the solar cell including the corresponding perovskite material.

In the embodiments of the present application, by doping the formamidinium cation-containing perovskite material with cesium cations having a relatively small ionic radius, the formation energy of the α-phase is effectively reduced by lowering the tolerance factor, and the formation of δ-phase impurities during the production process is reduced, thereby suppressing unfavorable phase transitions during the use of the perovskite material and improving the stability of the formamidinium cation-containing perovskite material. Moreover, since the radius of the N-containing monovalent cation is greater than that of the formamidinium cation, and the radius of the cesium cation is smaller than that of the formamidinium cation, the radii of the N-containing monovalent cation and the cesium cation are balanced with each other, which is conducive to reducing local tensile and compressive strains in the perovskite lattice and improving the stability of the formamidinium cation-containing perovskite material.

In some embodiments, B²⁺ includes Pb²⁺ and Sn²⁺, and a molar ratio of Pb²⁺ in B²⁺ ions is greater than 0 and less than 1.

The divalent cation B²⁺ includes at least two divalent cations, that is, at least includes a lead cation Pb²⁺ and a tin cation Sn²⁺, for regulating the bandgap of the formed perovskite material, so that the formed perovskite material has a relatively narrow bandgap, a relatively high absorption coefficient, and a relatively low free carrier recombination rate.

In some embodiments, the molar ratio of Pb²⁺ in the B²⁺ ions may be 0.01, 0.05, 0.1, 0.15, 0.2, 0.25, 0.3, 0.35, 0.4, 0.45, 0.5, 0.55, 0.6, 0.65, 0.7, 0.75, 0.8, 0.85, 0.9, 0.95, 0.99, or the like, or a range formed by any two of the above values, for example, may be 0.01 to 0.3, 0.1 to 0.45, 0.2 to 0.6, 0.3 to 0.7, 0.4 to 0.8, 0.5 to 0.9, 0.6 to 0.99, or the like.

In the embodiments of the present application, by selecting Pb²⁺ and Sn²⁺ as the metal cations, the bandgap of the formed perovskite material is regulated, so that the formed perovskite material has a relatively narrow bandgap, a relatively high absorption coefficient, and a relatively low free carrier recombination rate, thereby facilitating the improvement of the photoelectric conversion efficiency of the corresponding perovskite solar cell.

In some embodiments, the radius of the N-containing monovalent cation is greater than that of the formamidinium cation.

In the embodiments of the present application, since the radius of the N-containing monovalent cation is greater than that of the formamidinium cation, the doping with the N-containing monovalent cation having a relatively large radius balances with the radii of other A-site cations, thereby achieving regulation of lattice strain and stabilization of the α-phase without negatively affecting the bandgap.

In some embodiments, the N-containing monovalent cation includes one or more of a substituted or unsubstituted N-containing heterocyclic cation and a substituted or unsubstituted guanidinium cation.

The N-containing heterocyclic cation refers to an organic cation including a heterocyclic structure, where the elements constituting the heterocycle include at least one nitrogen atom N in addition to the carbon element. The chemical formula of the guanidinium cation is -NH-C(NH₂)=NH₂⁺. Substituted or unsubstituted N-containing heterocyclic cations and/or guanidinium cations have relatively large ionic radii, which are conducive to enhancing the stability of the formamidinium cation in the lattice, thereby stabilizing the crystalline phase structure of the perovskite material, achieving defect passivation of the perovskite material, and reducing ion migration channels, thereby improving the stability of the corresponding perovskite solar cells. In some embodiments, in the case where the N-containing monovalent cation includes a substituted or unsubstituted guanidinium cation, A⁺ does not include GA⁺. In some embodiments, in the case where A⁺ includes GA⁺, the N-containing monovalent cation does not include the substituted or unsubstituted guanidinium cation.

In the embodiments of the present application, by providing the N-containing monovalent cation, the hydrogen bonding interaction between the N-containing monovalent cation and the formamidinium cation is enhanced, and the migration of the formamidinium cation and the release of formamidine gas are reduced, thereby effectively improving the stability of the corresponding perovskite solar cell.

In some embodiments, the substituted or unsubstituted N-containing heterocyclic cation includes one or more of a substituted or unsubstituted pyrrolyl cation, a substituted or unsubstituted pyrrolidinyl cation, a substituted or unsubstituted piperidinyl cation, a substituted or unsubstituted pyridinyl cation, a substituted or unsubstituted pyrazinyl cation, a substituted or unsubstituted piperazinyl cation, and a substituted or unsubstituted 1,2,3,4-tetrahydro-[1,3,5]triazinyl cation.

The structural formula of the pyrrolyl cation is 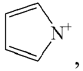 the structural formula of the pyrrolidinyl cation is 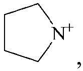 the structural formula of the piperidinyl cation is 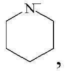 the structural formula of the pyridinyl cation is 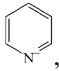 the structural formula of the pyrazinyl cation is 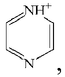 the structural formula of the piperazinyl cation is 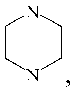 and the structural formula of the 1,2,3,4-tetrahydro-[1,3,5]triazinyl cation is 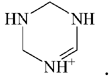 Substitution refers to the replacement of certain atoms or atomic groups in an organic molecule with other atoms or atomic groups.

In the embodiments of the present application, by providing the above-mentioned substituted or unsubstituted N-containing heterocyclic cation as the N-containing monovalent cation to dope the formamidinium cation-containing perovskite material, X vacancy defects inside the perovskite crystal and at grain boundaries are passivated, carrier recombination sites and ion migration channels are reduced, the lattice strain of the perovskite material is regulated, the crystalline phase of the perovskite material is stabilized, and the photoelectric conversion efficiency and stability of the perovskite solar cell are improved.

In some embodiments, the N-containing monovalent cation includes one or more of a substituted N-containing heterocyclic cation and a substituted guanidinium cation. A substituent group of the substituted N-containing heterocyclic cation and a substituent group of the substituted guanidinium cation are each independently selected from -D₁ and -L₁-D₁, where Li includes an aliphatic hydrocarbon group having 1 to 5 carbon atoms, and Di includes one or more of methyl, cyano, carboxyl, trifluoromethanesulfonyl, phenyl, pyridyl, benzylideneamino, amino, acetyl, formyl, halogen, phenyl substituted with 1 to 4 halogens, benzylideneamino substituted with 1 to 2 halogens, and (trifluoromethyl)phenyl.

An aliphatic hydrocarbon group refers to a group remaining after removing several hydrogen atoms from a hydrocarbon compound having the basic properties of an aliphatic compound. The chemical formula of methyl is -CH₃, the chemical formula of cyano is -CN, the chemical formula of carboxyl is -COOH, the structural formula of trifluoromethanesulfonyl is 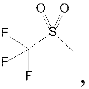 the structural formula of phenyl is 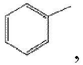 the structural formula of pyridyl is 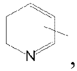 the structural formula of benzylideneamino is 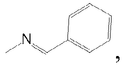 the chemical formula of amino is -NH₂, the structural formula of acetyl is 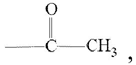 the chemical formula of formyl is -C=O, halogen includes -F (fluoro), -Cl (chloro), -Br (bromo), or -I (iodo), and the chemical formula of (trifluoromethyl)phenyl is

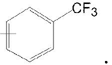

In the embodiments of the present application, by doping the formamidinium cation-containing perovskite material with a multifunctional N-containing cation, the X vacancy defects inside the perovskite crystal and at the grain boundaries are passivated, and the cation itself also plays a role in self-passivation, which is further beneficial to reducing defects inside the perovskite crystal and at the grain boundaries. In addition, the seed formation energy and crystal growth rate during the crystallization process can be regulated, further improving the crystalline quality of a formed perovskite layer, which is beneficial to further improving the photoelectric conversion efficiency of the corresponding perovskite solar cell.

In some embodiments, the N-containing monovalent cation includes one or more of 3-bromopyridinium cation, 1-cyanoguanidinium cation, 1-(trifluoromethanesulfonyl)guanidinium cation, 1-acetylguanidinium cation, 1,2,3,4-tetrahydro-[1,3,5]triazinium cation, 1-(2,6-dichlorobenzylideneamino)guanidinium cation, and 1-(2-chloroethyl)piperidinium cation.

The structural formula of the 3-bromopyridinium cation is 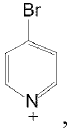 the structural formula of the 1-cyanoguanidinium cation is 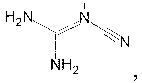 the structural formula of the 1-(trifluoromethanesulfonyl)guanidinium cation is 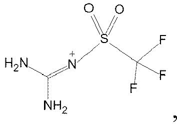 the structural formula of the 1-acetylguanidinium cation is 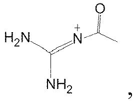 the structural formula of the 1,2,3,4-tetrahydro-[1,3,5]triazinium cation is 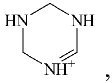 the structural formula of the 1-(2,6-dichlorobenzylideneamino)guanidinium cation is 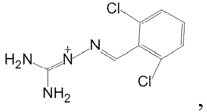 and the structural formula of the 1-(2-chloroethyl)piperidinium cation is

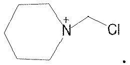

In the embodiments of the present application, by providing specific N-containing monovalent cations to dope the formamidinium cation-containing perovskite material, defects of the perovskite material are passivated, ion migration channels are reduced, the lattice strain of the perovskite material is regulated, the crystalline phase of the perovskite material is stabilized, and the stability of the corresponding solar cell 100 is improved.

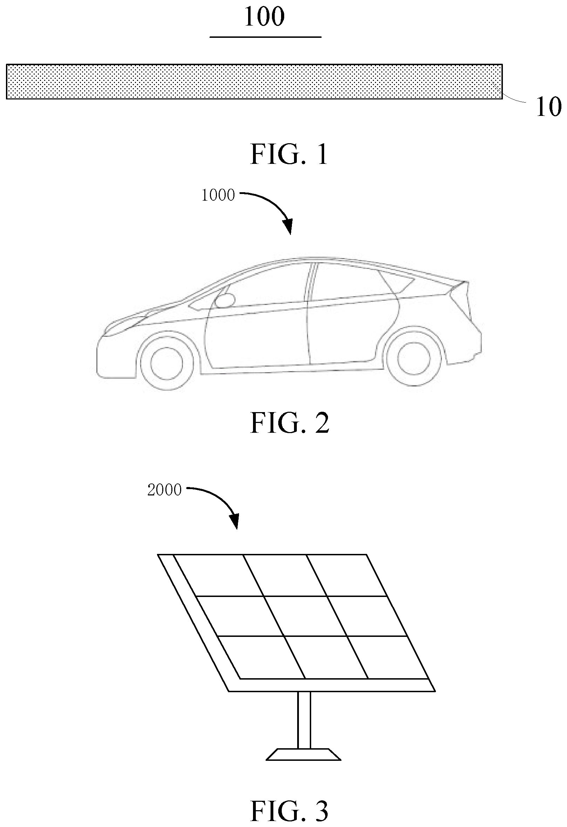

Referring to FIG. 1, FIG. 1 is a schematic structural diagram of a solar cell according to an embodiment of the present application.

According to a second aspect, referring to FIG. 1, an embodiment of the present application provides a solar cell 100. The solar cell 100 includes a light-absorbing layer 10. A material forming the light-absorbing layer 10 includes a perovskite material. The perovskite material is any one of the perovskite materials according to the first aspect.

The solar cell 100 refers to a device that converts light energy into electrical energy through the photovoltaic effect. The light-absorbing layer 10 refers to a core component of the solar cell 100, and is used for absorbing photon energy of sunlight, generating electron-hole pairs, and separating the electron-hole pairs into free electrons and holes under the action of a built-in electric field. The holes and the electrons are respectively collected by two different electrodes, and the two electrodes are connected into a circuit to generate a photocurrent.

In addition to the light-absorbing layer 10, the solar cell 100 may further include other film layer structures, such as a first electrode layer and a second electrode layer, where the light-absorbing layer 10 is located between the first electrode layer and the second electrode layer. The first electrode layer is used for collecting one of the electrons or the holes generated by the light-absorbing layer, and the second electrode is used for collecting the other one of the electrons or the holes generated by the light-absorbing layer.

In some embodiments, at least one of the first electrode layer and the second electrode layer is a transparent electrode for light incidence. In one example, the solar cell 100 further includes a substrate structure, and the substrate structure is used for supporting the functional film layers of the solar cell 100. The first electrode layer is disposed on the substrate structure. Further, both the first electrode layer and the substrate structure are made of transparent materials. It can be understood that in other examples, the second electrode layer may be disposed on the substrate structure, and both the second electrode layer and the substrate structure are made of transparent materials.

In some embodiments, the transparent electrode may be a transparent conductive metal oxide electrode. Without limitation, the material of the transparent electrode may be, for example but not limited to, one or more of the following materials: FTO (fluorine-doped tin oxide), ITO (tin-doped indium oxide), AZO (aluminum-doped zinc oxide), BZO (boron-doped zinc oxide), IZO (indium zinc oxide), IWO (tungsten-doped indium oxide), lanthanide metal-doped indium oxide, antimony-doped tin oxide, and the like. It can be understood that the substrate structure may use glass as a base, or may adopt a transparent flexible substrate structure. Specifically, the material of the transparent flexible substrate structure may be, for example, an organic polymer material, which may be formed by mixing one or more of the following materials in different proportions: polyvinyl alcohol (PVA), polyester (PET), polyimide (PI), polyethylene naphthalate (PEN), and polydimethylsiloxane (PDMS).

In some embodiments, the material of the electrode layer other than the transparent electrode includes a conductive material. Further, the conductive material may be an organic conductive material, an inorganic conductive material, or a combination thereof. Non-limiting examples of the inorganic conductive material include metallic conductive materials. Further, the metallic conductive material may include any one of gold (Au), silver (Ag), copper (Cu), aluminum (Al), nickel (Ni), chromium (Cr), bismuth (Bi), platinum (Pt), magnesium (Mg), and the like, or any suitable mixture of the foregoing elements. The conductive material may include a conductive oxide. Further, the conductive material may be a conductive oxide. Non-limiting examples of the conductive oxide may include one or more of FTO, ITO, IWO, AZO, and the like.

In some embodiments, the first electrode layer is a transparent electrode and serves as an electrode for first receiving incident light.

In some embodiments, the solar cell 100 may further include one or both of an electron transport layer and a hole transport layer, where the electron transport layer and the hole transport layer are respectively located on two sides of the light-absorbing layer 10, and are used for transporting and extracting electrons and holes, so as to provide photoelectric conversion efficiency of the solar cell 100. Further, in the case where the solar cell 100 includes the first electrode layer and the second electrode layer, the electron transport layer and the hole transport layer are optionally disposed between the first electrode layer and the second electrode layer. In some embodiments, the solar cell 100 includes the substrate structure, the first electrode layer, the hole transport layer, the light-absorbing layer 10, the electron transport layer, and the second electrode layer which are sequentially stacked, where the first electrode layer is a transparent electrode. In some other embodiments, the solar cell 100 includes the substrate structure, the first electrode layer, the electron transport layer, the light-absorbing layer 10, the hole transport layer, and the second electrode layer which are sequentially stacked, where the first electrode layer is a transparent electrode.

The present application does not specifically limit the hole transport material used in the hole transport layer, and electron transport materials commonly used in the art may be adopted. Without limitation, the hole transport material may include, but is not limited to, one or more of the following hole transport materials and derivatives thereof: 2,2',7,7'-tetra[N,N-di(4-methoxyphenyl)amino]-9,9'-spirobifluorene (Spiro-OMeTAD), methoxytriphenylamine-fluoroformamidine, poly[bis(4-phenyl)(2,4,6-trimethylphenyl)amine], poly(3,4-ethylenedioxythiophene):polystyrene sulfonic acid, poly(3-hexylthiophene), triptycene-based triphenylamine, 3,4-ethylenedioxythiophene-methoxytriphenylamine, N-(4-aniline)carbazole-spirobifluorene, polythiophene, phosphonic acid-based monolayers, carbazole-based monolayers, sulfonic acid-based monolayers, triphenylamine-based monolayers, aryl-based monolayers, metal oxides (which may be referred to as first metal oxides), copper iodide, and copper thiocyanate, where the metal element in the first metal oxide may include one or more of Ni, Mo, W, and Cu, for example, include nickel oxide (NiOₓ) and WO₃.

The present application does not specifically limit the electron transport material used in the electron transport layer, and electron transport materials commonly used in the art may be adopted. For example, the electron transport material includes one or more of fullerenes and derivatives thereof, imide compounds, metal oxides, metal sulfides, metal fluorides, cyano-containing polyphenylacetylene, boron-containing polymers, bathocuproine, bathophenanthroline, hydroxyquinoline aluminum, oxadiazole compounds, and quinone compounds. Exemplarily, the fullerenes and derivatives thereof include one or more of fullerene C60, fullerene C70, PCBM ([6,6]-phenyl-C61-methyl butyrate), and [6,6]-phenyl-C71-methyl butyrate (PC71BM). The imide compounds include one or more of perylene imide-based materials, naphthalimide-based materials, phthalimide, succinimide, N-bromosuccinimide, glutarimide, or maleimide. The metal elements in the metal oxides may include one or more of Mg, Ni, Cd, Zn, In, Pb, Mo, W, Sb, Bi, Cu, Hg, Ti, Ag, Mn, Fe, V, Sn, Zr, Sr, Ga, and Cr, such as one or more of tin oxide (SnO₂), zinc oxide (ZnO), and titanium oxide. The metal sulfides include, for example, indium sulfide or zinc sulfide. The metal fluorides include one or more of lithium fluoride (LiF), sodium fluoride, magnesium fluoride (MgF₂), and calcium fluoride (CaF₂).

The embodiment of the present application provides a solar cell 100 including any one of the above perovskite materials. Since the perovskite material has reduced defects, reduced ion migration channels, and a stable crystalline phase, the formed solar cell 100 has good stability.

According to a third aspect, an embodiment of the present application provides a method for preparing the solar cell 100, which includes:
(1) prepare a perovskite precursor solution according to a molar ratio of components of a perovskite material for forming a light-absorbing layer 10, where the perovskite material is any one of the perovskite materials according to the first aspect; and
(2) form the perovskite precursor solution on a substrate, followed by curing treatment to obtain the light-absorbing layer 10.

The curing treatment refers to a process of converting a liquid substance into a solid substance. In some embodiments, the curing treatment refers to a process of performing heat treatment under certain temperature conditions. In some embodiments, the curing treatment includes annealing treatment. It is a common measure to perform annealing treatment during the formation of the light-absorbing layer 10 from the perovskite precursor solution. The process parameters such as the temperature and duration of the annealing treatment are within the value ranges commonly used in the art, as long as the curing of the light-absorbing layer 10 can be achieved, and the present application does not impose limitations thereon. In some embodiments, the curing treatment is the annealing treatment. The annealing treatment is performed at a temperature ranging from 100°C to 150°C, and the annealing duration ranges from 10 min to 40 min.

In the embodiments of the present application, by providing the method for preparing the solar cell 100 and using the designed perovskite precursor solution, the light-absorbing layer 10 with reduced defects, reduced ion migration channels, and a stable crystalline phase is formed, thereby achieving an improvement in the stability of the solar cell 100.

In some embodiments, the perovskite precursor solution includes a precursor of the N-containing monovalent cation, and the precursor of the N-containing monovalent cation includes a salt of the N-containing monovalent cation.

In the embodiments of the present application, by providing the salt of the N-containing monovalent cation as the precursor of the N-containing monovalent cation, doping modification of the formamidinium cation-containing perovskite material is easily achieved.

In some embodiments, the anion corresponding to the salt of the N-containing monovalent cation includes one or more of iodide anion I⁻, bromide anion Br⁻, chloride anion Cl⁻, thiocyanate anion SCN⁻, carboxylate anion HCOO⁻, acetate anion CH₃COO⁻, trifluoroacetate anion CF₃COO⁻, methanesulfonate anion CH₃SO₃⁻, trifluoromethanesulfonate anion CF₃SO₃⁻, and cyanate anion CN⁻.

In the embodiments of the present application, by providing the above-mentioned specific anions corresponding to the salt of the N-containing monovalent cation, when the cation of the salt of the N-containing monovalent cation participates in the doping modification of the formamidinium cation-containing perovskite material, an anion thereof participates in forming the X-site anion of the formamidinium cation-containing perovskite material, thereby improving the utilization efficiency of the salt of the N-containing monovalent cation, and avoiding the introduction of anions other than the X-site anion into the reaction system, thus reducing adverse effects on the formed perovskite material.

In some embodiments, the precursor of the N-containing monovalent cation includes one or more of hydrochloride, bromate, iodate, thiocyanate, formate, acetate, trifluoroacetate, trifluoromethanesulfonate, and cyanate of 3-bromopyridine, 1-cyanoguanidine, 1-(trifluoromethanesulfonyl)guanidine, 1-acetylguanidine, 1,2,3,4-tetrahydro-[1,3,5]triazine, 1-(2,6-dichlorobenzylideneamino)guanidine, and 1-(2-chloroethyl)piperidine.

The structural formula of 3-bromopyridine is 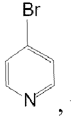 the structural formula of 1-cyanoguanidine is 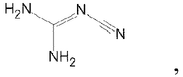 the structural formula of 1-(trifluoromethanesulfonyl)guanidine is 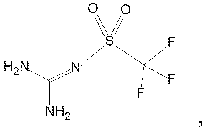 the structural formula of 1-acetylguanidine is 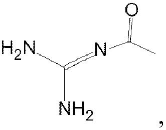 the structural formula of 1,2,3,4-tetrahydro-[1,3,5]triazine is 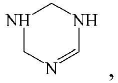 the hydrochloride salt of 1-(2,6-dichlorobenzylideneamino)guanidine is 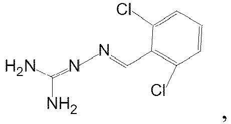 and the structural formula of 1-(2-chloroethyl)piperidine is

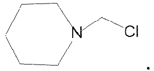

In the embodiments of the present application, by providing some specific precursors of the N-containing monovalent cation to dope the formamidinium cation-containing perovskite material, defects of the perovskite material is passivated, ion migration channels are reduced, the lattice strain of the perovskite material is regulated, the crystalline phase of the perovskite material is stabilized, and the stability of the corresponding solar cell 100 is improved.

Referring to FIG. 2, FIG. 2 is a schematic structural diagram of an electrical device according to an embodiment of the present application.

According to a fourth aspect, referring to FIG. 2, an embodiment of the present application provides an electrical device 1000, which includes the solar cell 100 according to the second aspect; or includes the solar cell 100 prepared by the method for preparing the solar cell 100 according to the third aspect.

In the embodiments of the present application, the solar cell 100 serves as an electric energy source for the electrical device 1000, enabling the normal operation of the electrical device 1000. The electrical device 1000 employs the solar cell 100 provided in the present application, and thus has at least the same advantages as the solar cell 100, which improves the cell performance of the electrical device 1000. By way of example, the electrical device 1000 may include lighting devices, display devices, new energy vehicles, or the like.

Referring to FIG. 3, FIG. 3 is a schematic structural diagram of power generation equipment according to an embodiment of the present application.

According to a fifth aspect, referring to FIG. 3, an embodiment of the present application provides power generation equipment 2000, which includes the solar cell 100 according to the second aspect; or includes the solar cell 100 prepared by the method for preparing the solar cell 100 according to the third aspect.

In the embodiments of the present application, the solar cell 100 serves as an energy source for the power generation equipment 2000, enabling the output of electrical energy from the power generation equipment 2000. The power generation equipment 2000 employs the solar cell 100 provided in the present application, and thus has at least the same advantages as the solar cell 100, which improves the power generation performance of the power generation equipment 2000. By way of example, the power generation equipment 2000 may be applied in fields such as building power supply, wearable device power supply, smartphone power supply, and vehicle battery power supply.

To make the technical problems solved by the embodiments of the present application, the technical solutions, and the beneficial effects of the present application clearer, further detailed description will be made below in conjunction with the embodiments and the accompanying drawings. Obviously, the described embodiments are only a part of the embodiments of the present application, rather than all of the embodiments. The following description of at least one exemplary embodiment is merely illustrative in nature and is in no way intended to limit the present application and the applications thereof. All other embodiments obtained by those of ordinary skill in the art based on the embodiments of the present application without making creative efforts shall fall within the protection scope of the present application.

The features and performance of the present application will be further described in detail below in conjunction with the embodiments.

### Example 1

### Preparation of Solar Cell 100

(1) Fluorine-doped tin dioxide conductive glass having the dimensions of 2.0 cm × 2.0 cm was taken, and 0.35 cm of fluorine-doped tin dioxide was removed from each of the two ends by laser etching to expose the glass substrate.
(2) The etched fluorine-doped tin dioxide conductive glass was ultrasonically cleaned sequentially with water, acetone, and isopropanol several times. The solvent on the surface of the fluorine-doped tin dioxide conductive glass was blown dry with a nitrogen gun, and then the glass was placed in an ultraviolet ozone generator for ultraviolet ozone treatment.
(3) A nano-sized nickel oxide precursor solution (with water as the solvent) having a concentration of 10 mg/mL was spin-coated onto the ultraviolet ozone-treated fluorine-doped tin dioxide conductive glass at a speed of 4000 rpm. The coated glass was annealed on a hot stage at 150°C for 30 min and then cooled to room temperature, thereby forming a hole transport layer having a thickness of 30 nm.
(4) 1.6 mmol of lead iodide (PbI₂), 1.504 mmol of formamidinium iodide (FAI), 0.08 mmol of cesium iodide (CsI), and 0.016 mmol of a dopant 3-bromopyridine hydrochloride ( 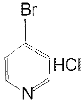 ) were weighed. The above materials were dissolved in 1 mL of a mixed solvent of DMF and DMSO at a volume ratio of 4:1, and stirred for 2 h. The resulting solution was then filtered through a 0.22 µm organic filter membrane to obtain a perovskite precursor solution. The perovskite precursor solution was spin-coated onto the obtained hole transport layer at a speed of 5000 rpm for 30 s, and 150 µL of anisole was added dropwise to the center of the substrate during the last 5 s. The coated substrate was annealed on the hot stage at 100°C for 40 min and then cooled to room temperature, thereby obtaining a light-absorbing layer 10 having a thickness of 500 nm.
(5) C60 having a thickness of 25 nm was deposited on the light-absorbing layer 10 by evaporation using a thermal evaporator to form an electron transport layer. Then, tin dioxide having a thickness of 20 nm was deposited on the surface of the electron transport layer by evaporation. Finally, Cu having a thickness of 120 nm was deposited on the surface of the tin dioxide by evaporation to serve as a second electrode layer, and the obtained cell device was designated as Cell 1.

Examples 2 to 4 were similar to Example 1, except that the molar amounts of formamidinium iodide and the dopant added in step (4) were different. Specifically, in step (4) of Example 2, the molar amount of formamidinium iodide added was 1.512 mmol, and the molar amount of the dopant added was 0.008 mmol. In step (4) of Example 3, the molar amount of formamidinium iodide added was 1.488 mmol, and the molar amount of the dopant added was 0.032 mmol. In step (4) of Example 4, the molar amount of formamidinium iodide added was 1.472 mmol, and the molar amount of the dopant added was 0.048 mmol.

Examples 5 to 10 were similar to Example 1, except that the dopant used in step (4) was different. The dopant used in Example 5 was 1-cyanoguanidine hydrochloride. The dopant used in Example 6 was 1-(trifluoromethanesulfonyl)guanidine hydrochloride. The dopant used in Example 7 was 1-acetylguanidine hydrochloride. The dopant used in Example 8 was 1,2,3,4-tetrahydro-[1,3,5]triazine hydrochloride. The dopant used in Example 9 was 1-(2,6-dichlorobenzylideneamino)guanidine hydrochloride. The dopant used in Example 10 was 1-(2-chloroethyl)piperidine hydrochloride.

Comparative Example 1 was similar to Example 1, except that no dopant was added in step (4), and the reagents dissolved in 1 mL of the mixed solvent of DMF and DMSO at the volume ratio of 4:1 were 1.52 mmol of FAI, 0.08 mmol of CsI, and 1.6 mmol of PbI₂.

Comparative Example 2 was similar to Example 1, except that the dopant added in step (4) was dimethylamine chloride.

Example 11 was similar to Example 1, except that the reagents dissolved in 1 mL of the mixed solvent of DMF and DMSO at the volume ratio of 4:1 in step (4) were 0.016 mmol of the dopant 3-bromopyridine hydrochloride, 1.264 mmol of FAI, 0.32 mmol of CsI, 0.9568 mmol of PbBr₂, and 0.6432 mmol of PbI₂.

Comparative Example 3 was similar to Example 11, except that no dopant was added in step (4), and the reagents dissolved in 1 mL of the mixed solvent of DMF and DMSO at the volume ratio of 4:1 were 1.28 mmol of FAI, 0.32 mmol of CsI, 0.96 mmol of PbBr₂, and 0.64 mmol of PbI₂.

Example 12 was similar to Example 1, except that the reagents dissolved in 1 mL of the mixed solvent of DMF and DMSO at the volume ratio of 4:1 in step (4) were 0.016 mmol of the dopant 3-bromopyridine hydrochloride, 0.16 mmol of CsI, 0.464 mmol of MAI, 0.96 mmol of FAI, 0.8 mmol of PbI₂, and 0.8 mmol of SnI₂.

Comparative Example 4 was similar to Example 12, except that no dopant was added in step (4), that is, the dissolved reagents were 0.16 mmol of CsI, 0.48 mmol of MAI, 0.96 mmol of FAI, 0.8 mmol of PbI₂, and 0.8 mmol of SnI₂.

Example 13 was similar to Example 1, except that the reagents dissolved in 1 mL of the mixed solvent of DMF and DMSO at the volume ratio of 4:1 in step (4) were 0.016 mmol of the dopant 3-bromopyridine hydrochloride, 1.584 mmol of FAI, and 1.6 mmol of PbI₂.

Comparative Example 5 was similar to Example 13, except that no dopant was added in step (4), and the reagents dissolved in 1 mL of the mixed solvent of DMF and DMSO at the volume ratio of 4:1 were 1.6 mmol of FAI and 1.6 mmol of PbI₂.

The solar cells 100 prepared in Examples 1 to 13 and Comparative Examples 1 to 5 above were subjected to relevant performance tests, and specific results are shown in Table 1.

### Performance Test of Solar Cell 100:

The test was performed according to the IEC61215 standard. A sunlight simulator from Enli Technology Co., Ltd. was used, and the light intensity was calibrated to one sun intensity (solar test standard AM 1.5) using a crystalline silicon solar cell. The solar cell 100 was connected to a digital source meter, and the initial photoelectric conversion efficiency thereof and the photoelectric conversion efficiency after aging at 85°C for 1000 h were measured under illumination. A ratio of the photoelectric conversion efficiency after aging at 85°C for 1000 h to the initial photoelectric conversion efficiency was calculated, and this ratio was a retention rate of the photoelectric conversion efficiency, which was used for characterizing the stability of the corresponding solar cell 100. During the aging process at 85°C for 1000 h, the solar cell 100 was maintained under a nitrogen atmosphere and dark conditions, with H₂O and O₂ in the environment kept at ≤ 0.1 ppm.

**Table 1: Test results of solar cell performance of Examples 1 to 13 and Comparative Examples 1 to 5**

| Item | Dopant | General Formula of Perovskite Material | Initial Photoelectric Conversion Efficiency | Photoelectric Conversion Efficiency after Aging at 85°C for 1000 h | Retention Rate of Photoelectric Conversion Efficiency |
|---|---|---|---|---|---|
| Comparative Example 1 | Not added | FA_{0.95}Cs_{0.05}PbI₃ | 20.18% | 10.34% | 51.24% |
| Comparative Example 2 | Dimethylamine chloride | M_{0.01}FA_{0.94}Cs_{0.05}PbI_{2.99}Cl_{0.01} | 22.03% | 13.34% | 60.55% |
| Example 1 | 3-Bromopyridine hydrochloride | M_{0.01}FA_{0.94}Cs_{0.05}PbI_{2.99}Cl_{0.01} | 23.32% | 16.82% | 72.13% |
| Example 2 | 3-Bromopyridine hydrochloride | M_{0.005}FA_{0.945}Cs_{0.05}PbI_{2.995}Cl_{0.005} | 23.18% | 15.49% | 66.82% |
| Example 3 | 3-Bromopyridine hydrochloride | M_{0.02}FA_{0.93}Cs_{0.05}PbI_{2.98}Cl_{0.02} | 22.12% | 15.82% | 71.52% |
| Example 4 | 3-Bromopyridine hydrochloride | M_{0.03}FA_{0.92}Cs_{0.05}PbI_{2.97}Cl_{0.03} | 20.91% | 12.91% | 61.74% |
| Example 5 | 1-Cyanoguanidine hydrochloride | M_{0.01}FA_{0.94}Cs_{0.05}PbI_{2.99}Cl_{0.01} | 23.12% | 18.20% | 78.72% |
| Example 6 | 1-(Trifluoromethanesulfonyl) guanidine hydrochloride | M_{0.01}FA_{0.94}Cs_{0.05}PbI_{2.99}Cl_{0.01} | 22.5% | 17.18% | 76.36% |
| Example 7 | 1-Acetylguanidine hydrochloride | M_{0.01}FA_{0.94}Cs_{0.05}PbI_{2.99}Cl_{0.01} | 22.7% | 19.85% | 87.44% |
| Example 8 | 1,2,3,4-Tetrahydro-[1,3,5]triazine hydrochloride | M_{0.01}FA_{0.94}Cs_{0.05}PbI_{2.99}Cl_{0.01} | 22.24% | 14.28% | 64.21% |
| Example 9 | 1-(2,6-Dichlorobenzylideneamino) guanidine hydrochloride | M_{0.01}FA_{0.94}Cs_{0.05}PbI_{2.99}Cl_{0.01} | 22.57% | 17.91% | 79.35% |
| Example 10 | 1-(2-Chloroethyl)piperidine hydrochloride | M_{0.01}FA_{0.94}Cs_{0.05}PbI_{2.99}Cl_{0.01} | 22.83% | 17.84% | 78.14% |
| Comparative Example 3 | Not added | FA_{0.8}Cs_{0.2}Pb(I_{0.60}Br_{0.40})₃ | 22.12% | 9.72% | 43.94% |
| Example 11 | 3-Bromopyridine hydrochloride | M_{0.01}FA_{0.79}Cs_{0.2}Pb(I_{0.60}Br_{0.40})_{2.99}Cl_{0.01} | 21.82% | 13.78% | 63.15% |
| Comparative Example 4 | Not added | Cs_{0.1}MA_{0.30}FA_{0.6}Pb_{0.5}Sn_{0.5}I₃ | 20.48% | Failed completely | 0 |
| Example 12 | 3-Bromopyridine hydrochloride | M_{0.01}Cs_{0.1}MA_{0.29}FA_{0.6}Pb_{0.5}Sn_{0.5}I_{2.99} Cl_{0.01} | 20.82% | 4.12% | 19.79% |
| Comparative Example 5 | Not added | FAPbI₃ | 18.27% | 7.13% | 39.03% |
| Example 13 | 3-Bromopyridine hydrochloride | M_{0.01}FA_{0.99}PbI_{2.99}Cl_{0.01} | 20.23% | 13.85% | 68.46% |

It can be seen from Table 1:
(1) Analysis of the experimental data of Comparative Example 1 and Example 1 to Example 4 shows that: compared with the solar cell 100 of the perovskite material not doped with the N-containing monovalent cation, the solar cell 100 of the perovskite material doped with the N-containing monovalent cation exhibits significant improvements in initial photoelectric conversion efficiency, photoelectric conversion efficiency after aging, and stability of photoelectric conversion efficiency.
(2) Analysis of the experimental data of Comparative Example 2 and Example 1 shows that: compared with additives doped with other non-N-containing monovalent cations, the solar cell 100 of the perovskite material doped with the N-containing monovalent cation exhibits significant improvements in initial photoelectric conversion efficiency, photoelectric conversion efficiency after aging, and stability of photoelectric conversion efficiency.
(3) Analysis of the experimental data of Example 1 to Example 4 shows that: as the doping ratio of the N-containing monovalent cation increases, the initial photoelectric conversion efficiency, the photoelectric conversion efficiency after aging, and the stability of the photoelectric conversion efficiency of the solar cell 100 of the perovskite material doped with the N-containing monovalent cation all show a trend of first increasing and then decreasing. Therefore, regulating the doping ratio of the N-containing monovalent cation is conducive to improving the related device performance of the solar cell 100.
(4) Analysis of the experimental data of Example 1 and Example 5 to Example 10 shows that: doping the perovskite material with different N-containing monovalent cations causes certain fluctuations in the initial photoelectric conversion efficiency, the photoelectric conversion efficiency after aging, and the stability of the photoelectric conversion efficiency of the corresponding solar cell 100, but overall, compared with the undoped Comparative Example 1, both the photoelectric conversion efficiency and the stability are improved to certain extent. Therefore, regulating the composition of the N-containing monovalent cation is conducive to improving the related device performance of the solar cell 100.
(5) Analysis of the experimental data of Example 1 and Example 11 to Example 13 shows that: the solar cells 100 of perovskite materials with different cations and/or different anions exhibit certain improvements in initial photoelectric conversion efficiency, photoelectric conversion efficiency after aging, and stability of photoelectric conversion efficiency compared with the corresponding undoped comparative examples. Therefore, it indicates that doping the perovskite material with the N-containing monovalent cation is applicable to various perovskite materials with different cations and anions, and regulating the composition of cations and/or anions of the perovskite material is conducive to improving the related device performance of the solar cell 100.
(6) Analysis of the experimental data of Comparative Example 3 and Example 11 shows that: compared with the solar cell 100 of the perovskite material not doped with the N-containing monovalent cation, the initial photoelectric conversion efficiency of the solar cell 100 of the perovskite material doped with the N-containing monovalent cation is somewhat reduced, but the photoelectric conversion efficiency after aging and the stability of the photoelectric conversion efficiency are both significantly improved.
(7) Analysis of the experimental data of Comparative Example 4 and Example 12 shows that: compared with the solar cell 100 of the perovskite material not doped with the N-containing monovalent cation, the solar cell 100 of the perovskite material doped with the N-containing monovalent cation exhibits significant improvements in initial photoelectric conversion efficiency, photoelectric conversion efficiency after aging, and stability of photoelectric conversion efficiency.
(8) Analysis of the experimental data of Comparative Example 5 and Example 13 shows that: compared with the solar cell 100 of the perovskite material not doped with the N-containing monovalent cation, the solar cell 100 of the perovskite material doped with the N-containing monovalent cation exhibits significant improvements in initial photoelectric conversion efficiency, photoelectric conversion efficiency after aging, and stability of photoelectric conversion efficiency.
(9) Analysis of the experimental data of Example 1 and Example 13 shows that: among perovskite materials including the N-containing monovalent cation, compared with the solar cell 100 of the perovskite material not including the cesium cation, the solar cell 100 of the perovskite material including the cesium cation exhibits significant improvements in initial photoelectric conversion efficiency, photoelectric conversion efficiency after aging, and stability of photoelectric conversion efficiency. Therefore, regulating the type and amount of cations in the perovskite material is conducive to improving the related device performance of the solar cell 100.
(10) Analysis of the experimental data of Comparative Example 4 and Example 12 shows that: among perovskite materials including the N-containing monovalent cation, the solar cell 100 of the perovskite material including mixed cations of methylammonium cation MA⁺ and formamidinium cation FA⁺ exhibits significant improvements in initial photoelectric conversion efficiency, photoelectric conversion efficiency after aging, and stability of photoelectric conversion efficiency. Therefore, regulating the type and amount of cations in the perovskite material is conducive to improving the related device performance of the solar cell 100.

In summary, in the embodiments of the present application, by doping the formamidinium cation-containing perovskite material with the N-containing monovalent cation, the stability of the corresponding solar cell 100 is improved.

To make the technical problems solved by the embodiments of the present application, the technical solutions, and the beneficial effects of the present application clearer, further detailed description will be made below in conjunction with the embodiments and the accompanying drawings. Obviously, the described embodiments are only a part of the embodiments of the present application, rather than all of the embodiments. The following description of at least one exemplary embodiment is merely illustrative in nature and is in no way intended to limit the present application and the applications thereof. All other embodiments obtained by those of ordinary skill in the art based on the embodiments of the present application without making creative efforts shall fall within the protection scope of the present application.

In the several embodiments provided in the present application, it should be understood that the disclosed systems, apparatuses, and methods may be implemented in other manners. For example, the apparatus embodiments described above are merely illustrative. For example, the division of units is only a logical functional division, and there may be other division manners in actual implementation. For example, multiple units or components may be combined or integrated into another system, or some features may be omitted or not performed. In another aspect, the mutual coupling, direct coupling, or communication connection shown or discussed may be indirect coupling or communication connection through some interfaces, apparatuses, or units, and may be in electrical, mechanical, or other forms.

In addition, each functional unit in the various embodiments of the present application may be integrated into one processing unit, or each unit may exist physically as a separate unit, or two or more units may be integrated into one unit. The above integrated units may be implemented in the form of hardware, or in the form of software functional units.

The above descriptions are only the implementations of the present application, and are not intended to limit the patent scope of the present application. Any equivalent structure or equivalent process transformation made by using the description and drawings of the present application, or direct or indirect application in other related technical fields, shall all be included in the patent protection scope of the present application.

## Claims

1. A perovskite material, wherein the general formula of the perovskite material is MₓFA_{y}A_{1-x-y}BX₃, 0 < x ≤ 0.1, 0.5 ≤ y < 1, and 1-x-y ≥ 0, wherein
M⁺ comprises an N-containing monovalent cation; FA⁺ is a formamidinium cation; A⁺ comprises at least one of inorganic or organic monovalent cations, B²⁺ comprises at least one inorganic divalent cation, and X⁻ comprises at least one monovalent anion.

2. The perovskite material according to claim 1, wherein A⁺ comprises one or more of MA⁺, Cs⁺, Rb⁺, K⁺, DMA⁺, EA⁺, and GA⁺; and/or B²⁺ comprises one or more of Pb²⁺, Sn²⁺, Ge²⁺, Cd²⁺, Sb²⁺, Zn²⁺, Mn²⁺, and Ca²⁺; and/or X⁻ comprises one or more of I⁻, Br⁻, Cl⁻, SCN⁻, HCOO⁻, CH₃COO⁻, CF₃COO⁻, CH₃SO₃⁻, CF₃SO₃⁻, and CN⁻.

3. The perovskite material according to claim 1 or 2, wherein X⁻ comprises I⁻, and a molar ratio of I⁻ in X⁻ ions is greater than or equal to 0.5.

4. The perovskite material according to any one of claims 1 to 3, wherein A⁺ comprises one or both of Cs⁺ and MA⁺; and a molar ratio of A⁺ in a sum of M⁺, FA⁺ and A⁺ ions is less than or equal to 0.4.

5. The perovskite material according to any one of claims 1 to 4, wherein A⁺ comprises Cs⁺, and a molar ratio of Cs⁺ in the sum of the M⁺, FA⁺ and A⁺ ions is less than or equal to 0.4.

6. The perovskite material according to any one of claims 1 to 5, wherein B²⁺ comprises Pb²⁺ and Sn²⁺, and a molar ratio of Pb²⁺ in B²⁺ ions is greater than 0 and less than 1.

7. The perovskite material according to any one of claims 1 to 6, wherein a radius of the N-containing monovalent cation is greater than that of the formamidinium cation.

8. The perovskite material according to any one of claims 1 to 7, wherein the N-containing monovalent cation comprises one or more of a substituted or unsubstituted N-containing heterocyclic cation and a substituted or unsubstituted guanidinium cation.

9. The perovskite material according to claim 8, wherein the substituted or unsubstituted N-containing heterocyclic cation comprises one or more of a substituted or unsubstituted pyrrolyl cation, a substituted or unsubstituted pyrrolidinyl cation, a substituted or unsubstituted piperidinyl cation, a substituted or unsubstituted pyridinyl cation, a substituted or unsubstituted pyrazinyl cation, a substituted or unsubstituted piperazinyl cation, and a substituted or unsubstituted 1,2,3,4-tetrahydro-[1,3,5]triazinyl cation.

10. The perovskite material according to claim 8 or 9, wherein the N-containing monovalent cation comprises one or more of a substituted N-containing heterocyclic cation and a substituted guanidinium cation; a substituent group of the substituted N-containing heterocyclic cation and a substituent group of the substituted guanidinium cation are each independently selected from -D₁ and -L₁-D₁, wherein
L₁ comprises an aliphatic hydrocarbon group having 1 to 5 carbon atoms, and D₁ comprises one or more of methyl, cyano, carboxyl, trifluoromethanesulfonyl, phenyl, pyridyl, benzylideneamino, amino, acetyl, formyl, halogen, phenyl substituted with 1 to 4 halogens, benzylideneamino substituted with 1 to 2 halogens, and (trifluoromethyl)phenyl.

11. The perovskite material according to any one of claims 1 to 10, wherein the N-containing monovalent cation comprises one or more of 3-bromopyridinium cation, 1-cyanoguanidinium cation, 1-(trifluoromethanesulfonyl)guanidinium cation, 1-acetylguanidinium cation, 1,2,3,4-tetrahydro-[1,3,5]triazinium cation, 1-(2,6-dichlorobenzylideneamino)guanidinium cation, and 1-(2-chloroethyl)piperidinium cation.

12. A solar cell, comprising:
a light-absorbing layer, wherein a material forming the light-absorbing layer comprises a perovskite material, wherein
the perovskite material is the perovskite material according to any one of claims 1 to 11.

13. A method for preparing a solar cell, comprising:
preparing a perovskite precursor solution according to a molar ratio of components of a perovskite material for forming a light-absorbing layer, wherein the perovskite material is the perovskite material according to any one of claims 1 to 11; and
forming the perovskite precursor solution on a substrate, followed by curing treatment to obtain the light-absorbing layer.

14. The method for preparing a solar cell according to claim 13, wherein the perovskite precursor solution comprises a precursor of the N-containing monovalent cation, and the precursor of the N-containing monovalent cation comprises a salt of the N-containing monovalent cation.

15. The method for preparing a solar cell according to claim 14, wherein an anion corresponding to the salt of the N-containing monovalent cation comprises one or more of I⁻, Br⁻, Cl⁻, SCN⁻, HCOO⁻, CH₃COO⁻, CF₃COO⁻, CH₃SO₃⁻, CF₃SO₃⁻, and CN⁻.

16. The method for preparing a solar cell according to any one of claims 13 to 15, wherein the perovskite precursor solution comprises the precursor of the N-containing monovalent cation, and the precursor of the N-containing monovalent cation comprises one or more of hydrochloride, bromate, iodate, thiocyanate, formate, acetate, trifluoroacetate, trifluoromethanesulfonate, and cyanate of 3-bromopyridine, 1-cyanoguanidine, 1-(trifluoromethanesulfonyl)guanidine, 1-acetylguanidine, 1,2,3,4-tetrahydro-[1,3,5]triazine, 1-(2,6-dichlorobenzylideneamino)guanidine, and 1-(2-chloroethyl)piperidine.

17. An electrical device, comprising the solar cell according to claim 12; or comprising a solar cell prepared by the method for preparing a solar cell according to any one of claims 13 to 16.

18. Power generation equipment, comprising the solar cell according to claim 12; or comprising a solar cell prepared by the method for preparing a solar cell according to any one of claims 13 to 16.
